# EUROPÄISCHE PATENTANMELDUNG

(11) **EP 4 756 437 A1**
(43) Veröffentlichungstag der Anmeldung: **10.06.2026**
(21) Anmeldenummer: 25217884.3
(22) Anmeldetag: 24.11.2025
(51) Int. Cl.: G01R 19/155, G01R 1/07

(54) **BERÜHRUNGSLOSER SPANNUNGSPRÜFER**

(30) Priorität: 03.12.2024 DE 102024211530
(71) Anmelder: Robert Bosch GmbH, 70442 Stuttgart (DE)
(72) Erfinder: Burman, Kunal Shyamadas, 70771 Echterdingen (DE); Zhang, Xinhui, Hangzhou, 311400 (CN); Kohlert, Thomas, 29780 Nerja (ES); Hahmann, Ann-Kathrin, 70195 Stuttgart (DE); Chan, Chi Fung, 73760 Ostfildern (DE); YING, Jianbang, Hangzhou, Zhejiang, 311400 (CN)

(57) **Zusammenfassung**

Die Erfindung betrifft ein Berührungsloser Spannungsprüfer (1), umfassend einen Mikrocontroller (2), welcher kommunikativ mit den nachfolgenden Komponenten verbunden ist:
- eine Sonde (4), um auf Basis einer elektromagnetischen oder elektrischen Feldinduktion eine Spannung zu erfassen,
- wenigstens zwei Ausgabemittel, welche auf Basis einer durch die Sonde (4) erfassten Spannung eine optische, akustische und/oder mechanische Ausgabe bereitstellen,
- ein Schalter (8), wobei der Schalter (8) einen Analog-Digital-Wandlungskanal (9) des Mikrocontrollers (2) mit den jeweiligen Ausgabemitteln verbindet.

Ferner betrifft die Erfindung ein Verfahren, ein Computerprogramm, eine Vorrichtung sowie ein Speichermedium zu diesem Zweck.

## Beschreibung

Die Erfindung betrifft einen berührungslosen Spannungsprüfer. Ferner betrifft die Erfindung ein Verfahren, ein Computerprogramm, eine Vorrichtung sowie ein Speichermedium zu diesem Zweck.

### Stand der Technik

Berührungslose Spannungsprüfer (englisch: "Non-contact voltage tester", NCVT), wurden entwickelt, um elektrische Spannungsfelder in Leitungen und Geräten zu erkennen, ohne dass ein direkter Kontakt mit dem stromführenden Leiter erforderlich ist. Berührungslose Spannungsprüfer sind in der Elektrotechnik weit verbreitet, um die Sicherheit von Fachkräften und Anwendern zu gewährleisten, indem sie eine schnelle und einfache Möglichkeit bieten, das Vorhandensein von gefährlichen Spannungen zu detektieren. Um eine Funktionalität des berührungslosen Spannungsprüfers zu gewährleisten, führt dieser einen Selbsttest von dessen Komponenten aus.

Die derzeitige Lösung gemäß dem Stand der Technik für diesen Selbsttest weist aufgrund von begrenzten Analog-Digital-Wandler(ADC)-Kanälen in Mikrocontrollern der berührungslosen Spannungsprüfer gravierende Einschränkungen sowohl auf der Komponenten- als auch auf der Schaltungsebene auf. Diese Limitierung der Analog-Digital-Wandler(ADC)-Kanäle schränkt auch eine Erweiterung von Produktfunktionen im Rahmen des Selbsttests des berührungslosen Spannungsprüfers ein.

### Offenbarung der Erfindung

Gegenstand der Erfindung ist ein Berührungsloser Spannungsprüfer mit den Merkmalen des Anspruchs 1, ein Verfahren mit den Merkmalen des Anspruchs 7, ein Computerprogramm mit den Merkmalen des Anspruchs 8, eine Vorrichtung mit den Merkmalen des Anspruchs 9 sowie ein
computerlesbares Speichermedium mit den Merkmalen des Anspruchs 10. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen berührungslosen Spannungsprüfer beschrieben sind, selbstverständlich auch im Zusammenhang mit dem erfindungsgemäßen Verfahren, dem erfindungsgemäßen Computerprogramm, der erfindungsgemäßen Vorrichtung sowie dem erfindungsgemäßen computerlesbaren Speichermedium, und jeweils umgekehrt, so dass bezüglich der Offenbarung der Erfindung stets auch eine wechselseitige Bezugnahme möglich ist.

Gegenstand der Erfindung ist insbesondere ein berührungsloser Spannungsprüfer, umfassend einen Mikrocontroller, welcher kommunikativ mit den nachfolgenden Komponenten verbunden ist:
- eine Sonde, um auf Basis einer elektromagnetischen oder elektrischen Feldinduktion eine Spannung zu erfassen,
- wenigstens zwei Ausgabemittel, welche auf Basis einer durch die Sonde erfassten Spannung eine optische, akustische und/oder mechanische Ausgabe bereitstellen,
- ein Schalter, wobei der Schalter einen Analog-Digital-Wandlungskanal des Mikrocontrollers mit den jeweiligen Ausgabemitteln verbindet.

Mit anderen Worten wird ein berührungsloser Spannungsprüfer beschrieben, der durch einen Mikrocontroller gesteuert wird, der eine Sonde, zwei oder mehr Ausgabemittel und einen Schalter umfasst. Die Sonde misst insbesondere elektrische Spannungen mithilfe elektromagnetischer oder elektrischer Feldinduktion. Der Mikrocontroller kann diese Messwerte verarbeiten und bei Erfassung einer Spannung durch die Sonde über die Ausgabemittel ein optische, akustische und/oder mechanische Anzeige der erkannten Spannung bereitstellen. Der Schalter ermöglicht es insbesondere wenigstens zwei Ausgabemittel über einen einzigen Analog-Digital-Wandlungskanal des Mikrocontrollers zu verbinden, wodurch vorteilhaft eine benötigte Anzahl an Analog-Digital-Wandlungskanälen reduziert werden kann. Dabei kann vorgesehen sein, dass zumindest der Summer und der Vibrationsmotor über den Schalter mit dem Analog-Digital-Wandlungskanal des Mikrocontrollers verbunden sind.

In einer weiteren Möglichkeit kann vorgesehen sein, dass die wenigstens zwei Ausgabemittel ausgewählt sind aus:
- einem Summer (englisch: "buzzer"), um die akustische Ausgabe bereitzustellen,
- einem Vibrationsmotor, um die mechanische Ausgabe bereitzustellen, d.h. insbesondere ein haptisches Feedback über eine Vibration,
- einer Spannungs-Leuchtdiode, um die optische Ausgabe bereitzustellen.

Die jeweilige akustische, mechanische und/oder optische Ausgabe erfolgt insbesondere dann, wenn über die Sonde eine Spannung erfasst wird. Die Spannungs-Leuchtdiode ist somit beispielsweise dafür vorgesehen zu leuchten, wenn über die Sonde eine Spannung erfasst wird. Dadurch kann eine vielfältige und konfigurierbare Ausgabe von Informationen an den Nutzer bereitgestellt werden. Die Kombination aus akustischen, mechanischen und optischen Signalen ermöglicht eine deutliche und differenzierte Warnung über die erfasste Spannung. Dies trägt beispielsweise zur Verbesserung der Benutzerfreundlichkeit und Sicherheit bei, da ein Anwender verschiedene Arten von Signalen wahrnehmen kann, unabhängig von den individuellen sensorischen Präferenzen oder Umgebungsbedingungen.

Es kann von Vorteil sein, wenn im Rahmen der Erfindung der Schalter ein analoger DPST-Schalter ist. Ein analoger DPST-Schalter (Double Pole, Single Throw) ist insbesondere ein elektrischer Schalter, der zwei separate Stromkreise gleichzeitig ein- oder ausschalten kann. "Double Pole" bedeutet, dass der Schalter zwei Kontakte (Pole) steuert, während "Single Throw" darauf hinweist, dass der Schalter nur eine Ein-Aus-Position hat. Es gibt also insbesondere keine Zwischenstellungen; beide Stromkreise werden gleichzeitig entweder verbunden oder getrennt. Mit einem DPST-Schalter können vorteilhaft zwei separate Stromkreise parallel gesteuert werden. Da beide Stromkreise vollständig getrennt werden können, erhöht dies insbesondere eine elektrische Sicherheit, beispielsweise in Systemen, die auf getrennte Spannungsquellen angewiesen sind.

Beispielsweise kann es vorgesehen sein, dass der berührungslose Spannungsprüfer ferner wenigstens eine Betriebsart-Leuchtdiode umfasst, wobei die wenigstens eine Betriebsart-Leuchtdiode eine Empfindlichkeitseinstellung des berührungslosen Spannungsprüfers anzeigt. Dies hat insbesondere den Vorteil, dass ein Anwender die Empfindlichkeitseinstellung des berührungslosen Spannungsprüfers visuell überblicken kann. Die Anzeigemöglichkeit der Betriebsart durch die wenigstens eine Betriebsart-Leuchtdiode ermöglicht dem Anwender eine einfache und intuitive Bedienung, da er die aktuelle Einstellung der Empfindlichkeit jederzeit direkt ablesen kann. Die Empfindlichkeit repräsentiert insbesondere einen Schwellwert für die elektromagnetische oder elektrische Feldinduktion, ab welchem die Sonde des berührungslosen Spannungsprüfers eine Spannung erfasst.

In einer weiteren Möglichkeit kann vorgesehen sein, dass der berührungslose Spannungsprüfer ferner wenigstens eine der nachfolgenden weiteren Komponenten umfasst, wobei der Schalter den Analog-Digital-Wandlungskanal des Mikrocontrollers mit der wenigstens einen weiteren Komponente verbindet:
- Wenigstens eine Schnittstelle, insbesondere drahtlose Schnittstelle, welche ausgebildet ist, um auf Basis der durch die Sonde erfassten Spannung eine Ausgabe an eine externe Datenverarbeitungsvorrichtung zu übermitteln,
- Wenigstens einen Hall-Sensor, um mit dem berührungslosen Spannungsprüfer ferner ein magnetisches Feld zu erfassen,
- Wenigstens einen Lidarsensor, um einen Abstand des berührungslosen Spannungsprüfers zu einem Hindernis zu ermitteln,
- Wenigstens einen Temperatursensor.

Die Schnittstelle kann beispielsweise eine WLAN- oder Bluetooth-Schnittstelle sein. Die externe Datenverarbeitungsvorrichtung kann beispielsweise ein Computer oder ein Smartphone eines Anwenders sein. Der Hall-Sensor ermöglicht die Erfassung von magnetischen Feldern, wodurch ein Einsatzbereich des Spannungsprüfers erweitert werden kann. Der Lidarsensor ermöglicht die Messung des Abstands zu Hindernissen, was die Sicherheit und Präzision des Geräts bei der Anwendung in komplexen Umgebungen erhöhen kann. Die Integration des Temperatursensors kann eine Überwachung einer Betriebstemperatur des Spannungsprüfers ermöglichen und dessen Lebensdauer verlängern. Diese zusätzlichen Funktionen tragen insbesondere zur Steigerung einer Leistungsfähigkeit und Anwendungsbreite des berührungslosen Spannungsprüfers bei.

Ebenfalls Gegenstand der Erfindung ist ein Verfahren zum Durchführen eines Selbsttests eines berührungslosen Spannungsprüfers gemäß einem der vorhergehenden Ansprüche umfassend:
- Überprüfen der wenigstens zwei Ausgabemittel und/oder der wenigstens einen weiteren Komponente des berührungslosen Spannungsprüfers unter Verwendung des Schalters, beispielsweise, indem die wenigstens zwei Ausgabemittel und/oder die wenigstens eine weitere Komponente elektrisch angesteuert werden/wird, um einen vorliegenden Kurzschluss oder eine Leitungsunterbrechung festzustellen,
- Initiieren einer Ausgabe auf Basis eines Ergebnisses des Überprüfens, beispielsweise visuell über eine Anzeigeeinheit des berührungslosen Spannungsprüfers oder akustisch über einen Lautsprecher des berührungslosen Spannungsprüfers.

Damit bringt das erfindungsgemäße Verfahren die gleichen Vorteile mit sich, wie sie ausführlich mit Bezug auf den berührungslosen Spannungsprüfer gemäß der Erfindung beschrieben worden sind. Das Überprüfen der wenigstens zwei Ausgabemittel und/oder der wenigstens einen weiteren Komponente des berührungslosen Spannungsprüfers kann in einer bestimmten Reihenfolge durchgeführt werden. Ferner kann im Rahmen des Selbsttests ein Batterie-, bzw. Akkustand des berührungslosen Spannungsprüfers überprüft werden.

Ebenfalls Gegenstand der Erfindung ist ein Computerprogramm, insbesondere Computerprogrammprodukt, umfassend Befehle, die bei der Ausführung des Computerprogrammes durch den berührungslosen Spannungsprüfer, insbesondere durch den Mikrocontroller des berührungslosen Spannungsprüfers, gemäß der Erfindung diesen veranlassen, das erfindungsgemäße Verfahren auszuführen. Damit bringt das erfindungsgemäße Computerprogramm die gleichen Vorteile mit sich, wie sie ausführlich mit Bezug auf ein erfindungsgemäßes Verfahren beschrieben worden sind.

Ebenfalls Gegenstand der Erfindung ist eine Vorrichtung zur Datenverarbeitung, die eingerichtet ist, das erfindungsgemäße Verfahren auszuführen. Als die Vorrichtung kann bspw. wenigstens ein Computer oder Mikrocomputer oder Mikrocontroller vorgesehen sein, welcher das erfindungsgemäße Computerprogramm ausführt und vorzugsweise in dem berührungslosen Spannungsprüfer integriert ist oder mit diesem kommunikativ verbunden ist. Die Vorrichtung zur Datenverarbeitung kann wenigstens einen Prozessor zur Ausführung des Computerprogramms aufweisen. Auch kann ein nicht-flüchtiger Datenspeicher vorgesehen sein, in welchem das Computerprogramm hinterlegt und von welchem das Computerprogramm durch den Prozessor zur Ausführung ausgelesen werden kann.

Ebenfalls Gegenstand der Erfindung kann ein computerlesbares Speichermedium sein, welches das erfindungsgemäße Computerprogramm aufweist und/oder Befehle umfasst, die bei der Ausführung durch den berührungslosen Spannungsprüfer gemäß der Erfindung diesen veranlassen, das erfindungsgemäße Verfahren auszuführen. Das Speichermedium ist bspw. als ein Datenspeicher wie eine Festplatte und/oder ein nicht-flüchtiger Speicher und/oder eine Speicherkarte ausgebildet. Das Speichermedium kann z. B. in den Computer integriert sein.

Darüber hinaus kann das erfindungsgemäße Verfahren auch als ein computerimplementiertes Verfahren ausgeführt sein. Alternativ oder zusätzlich kann zumindest einer der offenbarten Verfahrensschritte computer-implementiert sein und/oder automatisiert durchgeführt werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Visualisierung eines Verfahrens, einer Vorrichtung, eines Speichermediums sowie eines Computerprogramms gemäß Ausführungsbeispielen der Erfindung,
- Fig. 2: eine schematische Darstellung eines berührungslosen Spannungsprüfers gemäß Ausführungsbeispielen der Erfindung.

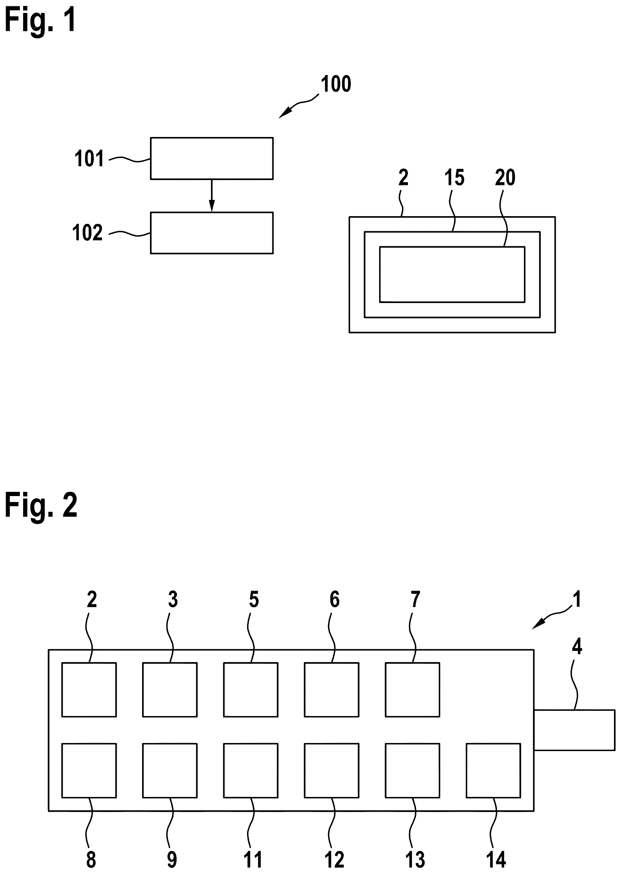

In Fig. 1 sind ein Verfahren 100, eine Vorrichtung 10, ein Speichermedium 15 sowie ein Computerprogramm 20 gemäß Ausführungsbeispielen der Erfindung schematisch dargestellt.

Fig. 1 zeigt insbesondere ein Verfahren 100 zum Durchführen eines Selbsttests eines berührungslosen Spannungsprüfers 1 gemäß der Erfindung. In einem ersten Schritt 101 werden die wenigstens zwei Ausgabemittel und/oder die wenigstens eine weitere Komponente des berührungslosen Spannungsprüfers 1 unter Verwendung des Schalters 8 überprüft. In einem zweiten Schritt 102 wird eine Ausgabe auf Basis eines Ergebnisses des Überprüfens initiiert.

Fig. 2 zeigt eine schematische Darstellung eines berührungslosen Spannungsprüfers 1 gemäß Ausführungsbeispielen der Erfindung. Dieser umfasst einen Mikrocontroller 2, einen Summer 3, eine Sonde 4, einen Vibrationsmotor 5, eine Spannungs-Leuchtdiode 6, eine Betriebsart-Leuchtdiode 7, einen Schalter 8, einen Analog-Digital-Wandler 9, eine Schnittstelle 11, insbesondere drahtlose Schnittstelle, welche ausgebildet ist, um die optische, akustische und/oder mechanische Ausgabe an eine externe Datenverarbeitungsvorrichtung zu übermitteln, einen Hall-Sensor 12, um mit dem berührungslosen Spannungsprüfer 1 ferner ein magnetisches Feld zu erfassen, einen Lidarsensor 13, um einen Abstand des berührungslosen Spannungsprüfers 1 zu einem Hindernis zu ermitteln, und einen Temperatursensor 14.

Der Summer 3 ist insbesondere ausgebildet, um eine akustische Ausgabe bereitzustellen. Der Vibrationsmotor 5 ist insbesondere ausgebildet, um eine mechanische Ausgabe bereitzustellen. Die Spannungs-Leuchtdiode 6 ist insbesondere ausgebildet, um eine optische Ausgabe bereitzustellen. Die Betriebsart-Leuchtdiode 7 zeigt insbesondere eine Empfindlichkeitseinstellung des berührungslosen Spannungsprüfers 1 an. Der Schalter 8 ist vorzugsweise ein analoger DPST-Schalter.

Zumindest der Summer 3 und der Vibrationsmotor 5 sind vorzugsweise über den Schalter 8 mit dem Analog-Digital-Wandlungskanal 9 des Mikrocontrollers 2 verbunden.

Ein Selbsttest eines berührungslosen Spannungsprüfers 1 wird insbesondere verwendet, um sicherzustellen, dass alle HMI-Komponenten (Human-Machine-Interface) und Sensorschaltungen funktionieren und in einer systematischen Reihenfolge arbeiten.

Ein einzelner Abtast-/Ballastwiderstand kann gemäß Ausführungsbeispielen im berührungslosen Spannungsprüfer 1 im Rahmen des Selbsttests verwendet werden. Ein zusätzlicher Schalter 8 in der Sensorschaltung kann verwendet werden, um eine Datenerfassung zu erleichtern. Darüber hinaus können mehrere Schalter 8 verwendet werden, um die Anzahl der Analog-Digital-Wandler 9 weiter zu verringern. Dadurch können vorteilhaft mehrere Komponenten des berührungslosen Spannungsprüfers 1 im Selbsttest mit einem einzigen Analog-Digital-Wandler 9 geprüft werden können.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

## Patentansprüche

1. Berührungsloser Spannungsprüfer (1), umfassend einen Mikrocontroller (2), welcher kommunikativ mit den nachfolgenden Komponenten verbunden ist:
- eine Sonde (4), um auf Basis einer elektromagnetischen oder elektrischen Feldinduktion eine Spannung zu erfassen,
- wenigstens zwei Ausgabemittel, welche auf Basis einer durch die Sonde (4) erfassten Spannung eine optische, akustische und/oder mechanische Ausgabe bereitstellen,
- ein Schalter (8), wobei der Schalter (8) einen Analog-Digital-Wandlungskanal (9) des Mikrocontrollers (2) mit den jeweiligen Ausgabemitteln verbindet.

2. Berührungsloser Spannungsprüfer (1) nach Anspruch 1,
**dadurch gekennzeichnet,**
**dass** die wenigstens zwei Ausgabemittel ausgewählt sind aus:
- einem Summer (3), um die akustische Ausgabe bereitzustellen,
- einem Vibrationsmotor (5), um die mechanische Ausgabe bereitzustellen,
- einer Spannungs-Leuchtdiode (6), um die optische Ausgabe bereitzustellen.

3. Berührungsloser Spannungsprüfer (1) nach Anspruch 2,
**dadurch gekennzeichnet,**
**dass** zumindest der Summer (3) und der Vibrationsmotor (5) über den Schalter (8) mit dem Analog-Digital-Wandlungskanal (9) des Mikrocontrollers (2) verbunden sind.

4. Berührungsloser Spannungsprüfer (1) nach einem der vorhergehenden Ansprüche,
**dadurch gekennzeichnet,**
**dass** der Schalter (8) ein analoger DPST-Schalter ist.

5. Berührungsloser Spannungsprüfer (1) nach einem der vorhergehenden Ansprüche,
**dadurch gekennzeichnet,**
**dass** der berührungslose Spannungsprüfer (1) ferner wenigstens eine Betriebsart-Leuchtdiode (7) umfasst, wobei die wenigstens eine Betriebsart-Leuchtdiode (7) eine Empfindlichkeitseinstellung des berührungslosen Spannungsprüfers (1) anzeigt.

6. Berührungsloser Spannungsprüfer (1) nach einem der vorhergehenden Ansprüche,
**dadurch gekennzeichnet,**
**dass** der berührungslose Spannungsprüfer (1) ferner wenigstens eine der nachfolgenden weiteren Komponenten umfasst, wobei der Schalter (8) den Analog-Digital-Wandlungskanal (9) des Mikrocontrollers (2) mit der wenigstens einen weiteren Komponente verbindet:
- Wenigstens eine Schnittstelle (11), insbesondere drahtlose Schnittstelle, welche ausgebildet ist, um auf Basis der durch die Sonde erfassten Spannung eine Ausgabe an eine externe Datenverarbeitungsvorrichtung zu übermitteln,
- Wenigstens einen Hall-Sensor (12), um mit dem berührungslosen Spannungsprüfer (1) ferner ein magnetisches Feld zu erfassen,
- Wenigstens einen Lidarsensor (13), um einen Abstand des berührungslosen Spannungsprüfers (1) zu einem Hindernis zu ermitteln,
- Wenigstens einen Temperatursensor (14).

7. Verfahren (100) zum Durchführen eines Selbsttests eines berührungslosen Spannungsprüfers (1) gemäß einem der vorhergehenden Ansprüche umfassend:
- Überprüfen (101) der wenigstens zwei Ausgabemittel und/oder der wenigstens einen weiteren Komponente des berührungslosen Spannungsprüfers (1) unter Verwendung des Schalters (8),
- Initiieren (102) einer Ausgabe auf Basis eines Ergebnisses des Überprüfens.

8. Computerprogramm (20), umfassend Befehle, die bei der Ausführung des Computerprogramms (20) durch den berührungslosen Spannungsprüfer (1) gemäß einem der Ansprüche 1 bis 6 diesen veranlassen, das Verfahren (100) nach Anspruch 7 auszuführen.

9. Vorrichtung (2) zur Datenverarbeitung, die eingerichtet ist, das Verfahren (100) nach Anspruch 7 auszuführen.

10. Computerlesbares Speichermedium (15), umfassend Befehle, die bei der Ausführung durch den berührungslosen Spannungsprüfer (1) gemäß einem der Ansprüche 1 bis 6 diesen veranlassen, die Schritte des Verfahrens (100) nach Anspruch 7 auszuführen.
